# EUROPEAN PATENT SPECIFICATION

(11) **EP 0 417 575 B1**
(45) Date of publication and mention of the grant of the patent: **21.12.1994**
(21) Application number: 90116793.2
(22) Date of filing: 31.08.1990
(51) Int. Cl.: G01R 31/36, H01C 10/12

(54) **Automatic battery tester with motor-driven carbon pile loading**
Automatischer Batterietester mit motorbetriebener Kohlenstoffzellenbelastung
Testeur de batterie automatique avec une mise en charge par pile de carbone contrôlée par moteur

(30) Priority: 11.09.1989 US 405447
(43) Date of publication of application: 20.03.1991
(73) Proprietor: SNAP-ON TOOLS CORPORATION, Kenosha, Wisconsin 53141-1410 (US)
(72) Inventor: Salley, Glenn E., Racine, Wisconsin 53402 (US); Becker, Thomas P., Kenosha, Wisconsin 53142 (US); Rameshk, Sohrab S., Libertyville, Illinois 60048 (US)
(74) Representative: Hauck, Hans, Dipl.-Ing.

(56) References cited:
- EP-A- 0 196 414
- DE-A- 2 803 014
- US-A- 4 352 067
- US-A- 4 613 822

## Description

### Background of the Invention

### Field of the Invention

The present invention relates to an apparatus for automatically loading a battery for testing thereof according to the preamble of claim 1.

### Description of the Prior Art

The testing of automotive batteries involves loading of the battery to a specified load current (typically one-half the rated cold cranking amperage) for a given period of time (typically about fifteen seconds), while monitoring the battery output voltage. Loading is accomplished by installing a variable impedance element across the battery. In prior battery testers, the impedance element has consisted of a carbon pile. The load resistance is adjusted by manually turning a knob on the carbon pile which is coupled to a threaded shaft which squeezes several carbon disks between a pair of brass plates. These brass plates are wired to the battery under test by means of heavy cables. Squeezing the carbon disks reduces the resistance between the plates, thereby increasing the load current.

One such manually-operated variable carbon pile impedance is disclosed in U.S. patent no. 4,613,822. That patent discloses a carbon pile which is adapted to be connected across the terminals of an associated circuit to be loaded, such as a battery, the pile being compressible between two plates by means of a pivoting cam mechanism which is operated by a manual lever for selectively varying the impedance of the carbon pile.

Battery voltage is measured across the battery terminals using a voltmeter. Load current can be measured by scaling the voltage drop across a low-resistance, low-temperature-coefficient, series resistor or by using a nonintrusive, inductive probe with associated amplifiers. The temperature within the carbon pile rises quickly as heavy current passes through it. This causes the resistance of the carbon pile to rise, directly lowering the load current. The manual load control must, therefore, be continuously readjusted to maintain the load at a predetermined current level throughout the test period.

### Summary of the Invention

It is a general object of the present invention to provide an improved battery test apparatus which avoids the disadvantages of prior battery testers, while affording additional structural and operating advantages.

An important feature of the present invention is the provision of an automatic battery loading apparatus.

In connection with the foregoing feature, it is another feature of the invention to provide a battery loading apparatus of the type set forth, wherein the loading element is a carbon pile.

Still another feature of the invention is the provision of a battery loading apparatus which will automatically maintain the load current at a predetermined level despite sensitivity of the impedance of the loading element to ambient conditions.

Still another feature of the present invention is the provision of a battery test device which incorporates a battery loading apparatus of the type set forth.

These and other features of the invention are attained by providing apparatus for automatically loading a battery (B) for testing thereof, comprising: mechanically variable electrical carbon pile impedance means adapted to be connected in series with the battery (B) for loading thereof, and compression means coupled to the impedance means for mechanically varying the compression thereof and thereby effecting variation of the impedance thereof, characterized by electric motor means for effecting operation of the compression means, feedback means coupled to the impedance means for generating a feedback signal proportional to the load current through the impedance means, drive control means coupled to the motor means and to the feedback means and responsive to the feedback signal for automatically controlling the operation of the motor means to maintain a predetermined load current through the impedance means.

### Brief Description of the Drawings

For the purpose of facilitating an understanding of the invention, there is illustrated in the accompanying drawings a preferred embodiment thereof, from an inspection of which, when considered in connection with the following description, the invention, its construction and operation, and many of its advantages should be readily understood and appreciated.
FIG. 1 is a perspective view of a battery tester constructed in accordance with and embodying the features of the present invention;
FIG. 2 is a partially block and partially schematic circuit diagram illustrating the connection of the battery tester of FIG. 1 to an associated battery under test;
FIG. 3 is an enlarged view in vertical section through the battery tester of FIG. 1, illustrating the carbon pile thereof;
FIG. 4 is a fragmentary sectional view, taken along the line 4-4 in FIG. 3; and
FIG. 5 is a schematic circuit diagram of the battery tester of FIG. 1.

### Description of the Preferred Embodiment

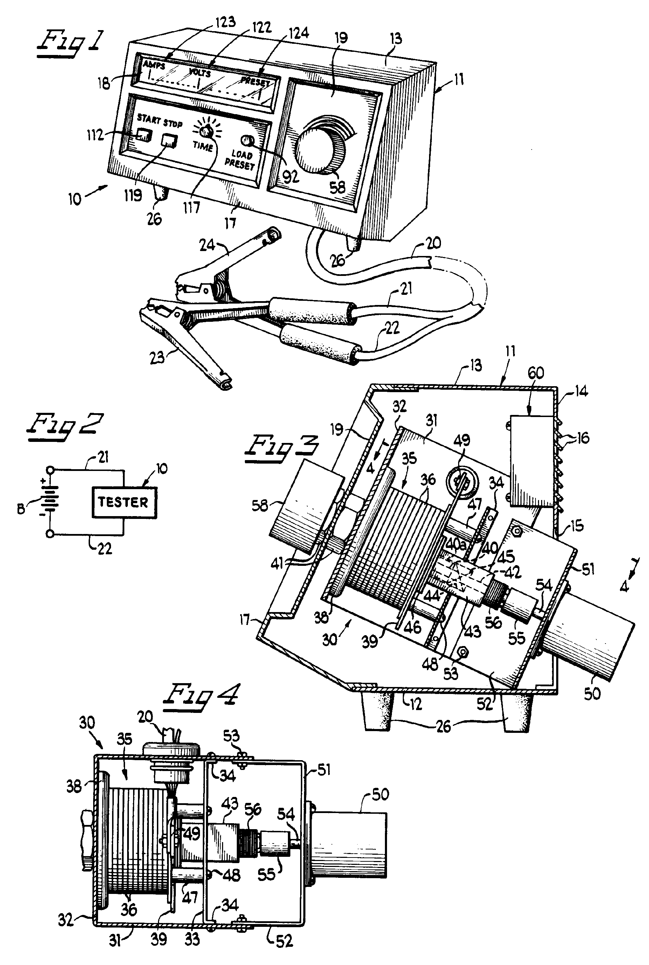

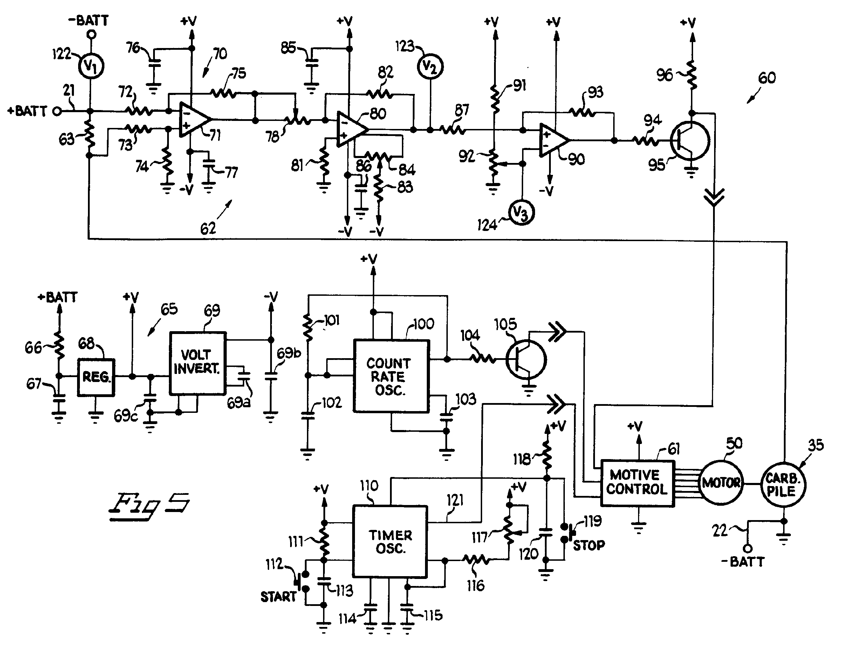

Referring to FIGS. 1-3, there is illustrated a battery tester, generally designed by the numeral 10, constructed in accordance with and embodying the features of the present invention. The battery tester 10 includes a cabinet 11 having a flat, rectangular bottom wall 12, a flat, rectangular top wall 13, and a rectangular rear wall 14 interconnecting the top and bottom walls 13 and 12 at the rear edges thereof. Formed in the rear wall 14 adjacent to a lower corner thereof is an opening 15, and formed in the rear wall 15 adjacent to the upper end thereof is a series of ventilation louvers 16. The front of the cabinet 11 is closed by a front panel 17 having a window 18 formed therein and provided with a rectangular recessed portion 19. A cable 20 including conductors 21 and 22 extends from the cabinet 11, the conductors 21 and 22 being respectively provided at their outer distal ends with clamp connectors 23 and 24 for clamping onto the terminal posts of an automotive battery B (FIG. 2) in standard fashion. The bottom wall 12 may be provided with a plurality of support legs 26 for supporting the cabinet 11 on an associated support surface.

Referring now also to FIG. 4, a mechanically variable impedance in the form of a carbon pile assembly 30 is disposed in the cabinet 11 . The carbon pile assembly 30 includes a generally U-shaped main mounting bracket 31 having a bight portion 32 and legs adapted to be coupled by suitable means to an associated wall structure (not shown) in the cabinet 11. The assembly 30 also includes a rear mounting bracket 33 which is generally channel-shaped and has a pair of attachment legs 34 respectively secured to the legs of the main bracket 31 for interconnecting same. A carbon pile 35 is disposed between the rear mounting bracket 33 and the bight 32 of the main mounting bracket 31, the carbon pile 35 including a plurality of annular carbon discs 36 stacked between front and rear brass terminal plates 38 and 39.

An elongated cylindrical shaft 40 (FIG. 3) extends coaxially through the carbon pile 35 for rotation with respect thereto. The forward end of the shaft 40 extends outwardly through a complementary opening in the recessed portion 19 of the cabinet front panel 17 and is axially retained in place with respect thereto by a suitable coupling including lock nuts 41. The shaft 40 is provided at its inner end with an externally threaded portion 42 which is threadedly engaged with a rectangular compression nut 43. The nut 43 has an axial recess 44 formed in the outer end thereof for receiving a cylindrical insulator 40a encircling the portion of the shaft 40 which passes through the carbon pile 35. Disposed in the recess 44 and encircling the shaft 40 is a helical compression spring 45 which bears against the cylindrical insulator and against the compression nut 43 at the inner end of the recess 44 therein for urging the nut 43 rearwardly.

A plurality of bearing washers 46 are disposed about the shaft 40 between the compression nut 43 and the rear terminal plate 39. The terminal plate 39 is spaced from the rear mounting bracket 33 by a plurality of hollow cylindrical ceramic standoffs 47 which are secured to the rear mounting bracket 33 by fasteners 48, and which maintain a predetermined minimum separation between the rear mounting bracket 33 and the rear terminal plate 39. One conductor of the cable 20 is coupled by a suitable connection 49 to the rear terminal plate 39, while the other conductor is coupled by a suitable connection (not shown) to the front terminal plate 38.

The carbon pile assembly 30 also includes an electric stepper motor 50 which is fixedly secured to a bight 51 of a generally U-shaped mounting bracket 52, the legs of which are respectively fixedly secured by suitable fasteners 53 to the legs of the main mounting bracket 31. The motor 50 has an output shaft 54 which is coupled by a suitable coupler 55 to the shaft 40 for rotation thereof, a plurality of washers 56 being disposed between the coupler 55 and the compression nut 43. The front end of the shaft 40 which projects outwardly beyond the front panel 17 of the cabinet 11 is secured to a suitable adjustment knob 58 for effecting manual rotation of the shaft 40, as will be explained in greater detail below.

In operation, when the shaft 40 is rotated, the compression nut 43 travels axially therealong, either outwardly or inwardly, depending upon the direction of rotation of the shaft 40, the compression nut 43 being held against rotation by engagement with the mounting plate 33. As the compression nut 43 moves axially outwardly along the shaft 40 against the urging of the compression spring 45, it causes the washers 46 to bear against the rear terminal plate 39 for compressing the carbon pile 35 between the terminal plates 38 and 39. Compressing the carbon pile 35 reduces the resistance between the discs 36 in a well-known manner, the reduction in resistance being proportional to the magnitude of the compressive force exerted on the carbon pile 35. When the shaft 40 is rotated in the opposite direction, the compression nut 43 is moved away from the carbon pile 35, reducing the compressive force thereon and increasing the resistance thereof, the movement being aided by the spring 45. It will be appreciated that the shaft 40 may be rotated manually by the use of the adjustment knob 58, and may be rotated automatically by the use of the stepper motor 50.

Referring now also to FIG. 5 there is illustrated a control assembly, generally designated by the numeral 60, for controlling the operation of the stepper motor 50, and thereby the variation in the resistance of the carbon pile 35. The control assembly 60 includes a motive control circuit 61, which is preferably an integrated circuit which includes an up/down, eight-bit binary counter which can operate in either a count-up or a count-down mode to provide a bipolar chopper drive. The motive control circuit 61 provides a parallel binary output to the stepper motor 50, which is a bipolar motor and may be provided with a suitable gear reduction. The bipolar configuration uses 100% of the motor windings and current flow is switched in a known manner. This configuration provides a high output of torque at low speeds. It will be appreciated that, as the counter of the motive control circuit 61 counts up, the motor 50 rotates in a first direction to increase the compressive force on the carbon pile 35, thereby decreasing its resistance and increasing the load current drawn thereby. When the motive control circuit 61 counts down, the motor 50 is rotated in the opposite direction to decrease the load current drawn by the carbon pile 35.

The control assembly 60 is coupled to the conductors 21 and 22 of the cable 20, and the carbon pile 35 is connected across the conductors 21 and 22. The control assembly 60 has a feedback circuit 62 which includes a feedback resistor 63 connected in series with the carbon pile 35. The control assembly 60 further includes a power supply circuit 65. More specifically, a resistor 66 and a capacitor 67 are connected in series between the positive battery voltage and ground, the junction between the resistor 66 and the capacitor 67 being coupled to the input of a voltage regulator 68, the output of which provides a regulated +V supply voltage which is preferably +5 VDC. The output of the voltage regulator 68 is also applied to a voltage inverter 69 and, through the operation of associated capacitors 69a and 69b to generate -V supply voltage, which is preferably -5 VDC. A bypass capacitor 69c provides stabilization to prevent oscillation in the power supply 65.

The voltage drop across the feedback resistor 63 is applied through a differential amplifier circuit 70 which includes an operational amplifier 71. More specifically, the positive and negative terminals of the feedback resistor 63 are respectively coupled through resistors 72 and 73 to the inverting and non-inverting input terminals of the operational amplifier 71. Also connected between the non-inverting input terminal and ground is a resistor 74. The output terminal of the operational amplifier 71 is coupled through a feedback resistor 75 to the inverting input terminal. The +V and -V supply voltages are applied to the operational amplifier 71, the capacitors 76 and 77 providing noise-reducing shunts to ground.

The feedback resistor 63 may have a resistance of 250 micro-ohms, in which case a currant of 500 amps therethrough will develop a voltage drop across it of 125 millivolts. The amplifier 70 provides a differential input circuit which references the voltage drop across the feedback resistor 63 to ground. It will be appreciated that the voltage drop across the feedback resistor 63 is proportional to the load current through the carbon pile 35. The operational amplifier 71 is preferably set to a gain of -1.

The output of the operational amplifier 71 is coupled through a trim pot 78 to the inverting input terminal of a scale adjustment operational amplifier 80, which is arranged in an inverting configuration with the non-inverting input terminal thereof being coupled through a resistor 81 to ground. The output terminal of the operational amplifier 80 is coupled through a feedback resistor 82 to the inverting input terminal. The +V and -V supply voltages are applied directly to the operational amplifier 80 through connections which are respectively provided with suitable noise bypass capacitors 85 and 86. The -V supply voltage is also applied through a resistor 83 and a potentiometer 84. The gain of the operational amplifier 80 is established by the ratio of feedback resistor 82 to trim pot 78. Resistor 81 serves to limit input offset currents, and the resistor 83 and the potentiometer 84 provide offset voltage compensation. Preferably, the gain of the operational amplifier 80 is set at -4, yielding an output of 0.5 volts for the -0.125 volt input from the differential amplifier 70.

The output of the operational amplifier 80 is coupled through a resistor 87 to the non-inverting input terminal of an operational amplifier 90, which is configured as a voltage comparator. The inverting input terminal of the operational amplifier 90 is coupled to the wiper of a potentiometer 92, which is connected in series with a resistor 91 between the +V supply and ground. The +V and -V supply voltages are also applied directly to the operational amplifier 90. The output terminal of the operational amplifier 90 is coupled through a feedback resistor 93 to the non-inverting input terminal thereof. The potentiometer 92 is preferably mounted on the front panel 17 of the cabinet 11, and a preset voltage is established through the resistor 91 and the potentiometer 92, the values of which are selected to provide a 0 to 0.5 volt range into the inverting input terminal of the operational amplifier 90. The resistor 93 provides hysteresis across the comparator to slow down the "searching" rate of the feedback-control circuit 62. Functionally, when the scaled load "feedback" voltage from operational amplifier 80 is lower than the preset level, the output of operational amplifier 90 is low (e.g., -5 volts). When the output from the operational amplifier is higher than the preset level, the output of the operational amplifier 90 is high (e.g. +5 volts).

The output from the comparator operational amplifier 90 is applied through a resistor 94 to the base of a transistor 95, the emitter of which is grounded and the collector of which is coupled through a resistor 96 to the +V supply. The collector of the transistor 95 is also coupled to the motive control circuit 61. The transistor 95 functions as an inverter and serves to make the output from the comparator operational amplifier 90 single-ended, i.e., non-negative going. Thus the low output from operational amplifier 90 will become +5 volts, corresponding to a logical "1", while the high output from operational amplifier 90 will become 0 volts, corresponding to a logical "0". The resistor 94 provides current limit into the base of the transistor 95, and the resistor 96 provides the collector load. The collector of the transistor 95 provides a direction control signal to the motive control circuit 61 to tell it in which direction to count, for thereby controlling the direction of rotation of the stepper motor 50.

The count-up, count-down function is provided by an integrated circuit count rate oscillator 100. The oscillator 100 is provided with the +V supply voltage and has an oscillator input coupled through a resistor 101 to the output terminal of the oscillator and through a capacitor 102 to ground, the values of the resistor 101 and the capacitor 102 determining the count rate. A bypass capacitor 103 is connected to ground to stabilize the oscillator 100 and to eliminate spikes from the high speed switching of the motive control circuit 61. The oscillator 100 is a free running oscillator and preferably has an output of about 300 Hz, which is applied through a resistor 104 to the base of a transistor 105, which is configured as an inverter, with its emitter grounded and with its collector providing an output signal to the motive control circuit 61.

The control assembly 60 also includes an integrated circuit timer oscillator 110. A resistor 111 is connected across input terminals of the timer oscillator 110, the resistor 111 being connected in series with a normally-open push-button start switch 112 between the +V supply voltage and ground. A capacitor 113 is connected in parallel with the start switch 112. The capacitors 114 and 115 are connected to other terminals of the timer oscillator 110. A resistor 116 and a trim pot 117 are connected in series between the +V supply and another input terminal of the timer oscillator 110. Another input terminal of the timer oscillator 110 is connected through a resistor 118 to the +V supply voltage and through a normally-open push-button stop switch 119 to ground, a capacitor 120 being connected in parallel with the stop switch 119. The timer oscillator 110 has an output terminal 121 coupled to the motive control circuit 61.

In operation, when the start switch 112 is closed, the timer oscillator 110 starts to time out a predetermined time period, which time period is set by the values of the capacitor 115 and the combined resistance of the resistor 116 and the trim pot 117. When the timer is triggered, the timer oscillator 110 will produce an output signal on its output terminal 121 to the motive control circuit 61 to enable that circuit, this output signal continuing as long as the timer is operating. The stop switch 119 is connected so that if it is closed before the timer has timed out, it will terminate the output signal on the conductor 121 and reset the timer to zero. The resistors 111 and 118 are pull-up resistors for the start switch 112 and the stop switch 119, respectively, and the capacitors 113 and 120 are for noise reduction and the capacitor 114 is for stabilization and spike elimination. Preferably, the start switch 112 and the stop switch 119 are mounted on the front panel 17 of the cabinet 11. Preferably, the predetermined time period of the timer oscillator 110 is set for about a 15-second test period. The potentiometer 117 may be mounted on the front panel 17 of the cabinet 11.

Preferably, indicating meters are provided for monitoring the operation of the battery tester 10. In particular, a voltmeter 122 is coupled across the battery terminals, i.e., across the conductors 21 and 22, to continually monitor the output voltage of the battery B. A volt meter 123 may be connected to the output terminal of the scale adjust operational amplifier 80 for monitoring the scaled feedback voltage measured across the feedback resistor 63, which is proportional to the load current through the carbon pile 35. The meters 122 and 123 may be mounted inside the front panel 17 of the cabinet 11 for display through the window 18. The meter 123 may be calibrated in amperes to directly read the load current. There may also be provided a meter 124 coupled to the wiper of the potentiometer 92 for monitoring the preset voltage level, which is proportional to the predetermined load current which is to be maintained by the control assembly 60. This meter may also be calibrated to read load current directly, and may also be mounted in the cabinet 11 for display through the window 18 or another suitable window.

In operation, the potentiometer 117 is adjusted to set the predetermined time period of the timer oscillator 110. The clamp connectors 23 and 24 are then connected to the terminals of the battery B and the carbon pile 35 is manually adjusted by means of the adjustment knob 58 to zero the carbon pile 35, i.e., to relieve the pressure on it until a substantially zero load current reading is obtained on the meter 123. The potentiometer 92 is adjusted until the meter 124 reads the desired predetermined load current which is to be maintained during the battery test.

The start switch 112 is then closed, triggering the timer oscillator 110 to initiate the predetermined time period and generate the output signal on terminal 121 for enabling the motive control circuit 61. Since the carbon pile 35 has been initially zeroed, there will initially be a negligible load current. Thus, the voltage measured by the meter 123 will be much less than the preset voltage, so that the output of the comparator 90 will be a logical "0", which causes the counter in the motive control circuit 61 to operate in a count-up mode to start to count at the rate determined by the count rate oscillator 100 to step the motor 50 in a first direction for compressing the carbon pile 35. The load current through the carbon pile 35 will rapidly increase as it is compressed until the feedback voltage, as measured by the meter 123, is substantially equal to the preset voltage, as measured by the meter 124.

Should the temperature of the carbon pile 35 cause a reduction of load, the counter of the motive control circuit 61 is again switched into the count-up mode for maintaining the predetermined load current. Similarly, should the feedback voltage increase beyond the preset value, the counter in the motive control circuit 61 is switched into a count-down mode to reduce the applied load to the predetermined level. The feedback circuit 62 will continue to "hunt" in this manner about the predetermined load level until the predetermined time period of the timer oscillator 110 terminates. Upon removal of the output signal from the timer oscillator 110, the counter in the motive control circuit 61 will count back down to zero for essentially removing the load applied by the carbon pile. During the test, the operator will monitor the voltmeter 122 to determine the loaded output voltage of the battery B.

In a constructional model of the battery tester 10, the operational amplifiers 71 and 80 may be of the type designated LM725C and sold by National Semiconductor, while the operational amplifier 90 may be of the type designated LM393 and sold by Motorola. The voltage regulator 68 may be of the type designated LM7805 and sold by National Semiconductor. The voltage inverter 69 may of the type designated ICL7660N sold by Intersil. The count rate oscillator circuit 100 and timer oscillator circuit 110 may both be timer circuits of the type designated LM555 and sold by National Semiconductor. The motive control circuit 61 may be a bipolar motor drive driver module of the type designated GS-D200 and sold by SGS Thomson, or a bipolar stepper drive of the type designated SD2 and sold by PKS Digiplan Ltd.

From the foregoing, it can be seen that there has been provided an improved battery tester which affords automatic loading of a battery and maintenance of a predetermined load current through the battery for testing it under load.

## Claims

1. Apparatus (10) for automatically loading a battery (B) for testing thereof, comprising: mechanically variable electrical carbon pile impedance means (35) adapted to be connected in series with the battery (B) for loading thereof, and compression means (32-34, 38-45) coupled to said impedance means (35) for mechanically varying the compression thereof and thereby effecting variation of the impedance thereof, characterized by electric motor means (50) for effecting operation of said compression means (32-34, 38-45), feedback means (62) coupled to said impedance means (35) for generating a feedback signal proportional to the load current through said impedance means (35), and drive control means (60) coupled to said motor means (50) and to said feedback means (62) and responsive to said feedback signal for automatically controlling the operation of said motor means (50) to maintain a predetermined load current through said impedance means (35).

2. The apparatus of claim 1, wherein said compression means includes a rotatable shaft (40) extending through said carbon pile impedance means, means (43) threadedly engaged with said shaft (40) and adapted for engagement with said carbon pile impedance means (35), and characterized by means (55) coupling said shaft (40) to said electric motor means (50) for rotating said shaft (40).

3. The apparatus of claim 1, characterized in that said electric motor means is an electric stepper motor (50), said drive control means (60) including means (61) for providing a binary drive signal to said stepper motor (50).

4. The apparatus of claim 1, characterized in that said drive control means (60) includes means (58) for manually adjusting said carbon pile impedance means (35) to a nominally zero-impedance condition.

5. The apparatus of claim 1, characterized in that said feedback means (62) includes resistance means (63) connected in series with said carbon pile impedance means (35), and means (70) for sensing the voltage drop across said resistance means (63).

6. The apparatus of claim 5, characterized by means (123) for indicating the load current through said carbon pile impedance means (35).

7. The apparatus of claim 1, characterized in that said drive control means (60) includes means (90) for comparing said feedback signal to a signal proportional to said predetermined load current.

8. The apparatus of claim 7, characterized by means (124) for indicating said predetermined current.

9. The apparatus of claim 1, characterized by timing means (110-121) coupled to said drive control means (60) for controlling the time period during which said predetermined load current is maintained.

10. The apparatus of claim 9, characterized by means (117) for adjusting said time period.

11. The apparatus of claim 1, characterized in that said drive control means (60) includes means (61, 90, 110) for decreasing the impedance of said impedance means (35) for increasing the load current from zero to said predetermined load current when said time period time begins, and means for increasing the impedance of said impedance means (35) for reducing the load current from said predetermined load current back to zero when said predetermined time period ends.

## Patentansprüche

1. Vorrichtung (10) zum automatischen Belasten einer Batterie (B) zwecks Prüfung, mit: mechanisch veränderlichen Kohleplattenstapel-Impedanzmitteln (35), die mit der Batterie (B) zwecks Belastung in Reihe schaltbar sind, und Kompressionsmitteln (32-34, 38-45), die mit den Impedanzmitteln (35) gekoppelt sind, um deren Kompression mechanisch zu ändern und dadurch eine Änderung ihrer Impedanz zu erzielen, gekennzeichnet durch einen elektrischen Motor (50) zum Betätigen der Kompressionsmittel (32-34, 38-45), Rückkopplungsmittel (62), die mit den Impedanzmitteln (35) gekoppelt sind, um ein Rückkopplungssignal zu erzeugen, das dem Laststrom durch die Impedanzmittel (35) proportional ist, und Antriebssteuermittel (60), die mit dem Motor (50) und den Rückkopplungsmitteln (62) gekoppelt sind und in Abhängigkeit von dem Rückkopplungssignal den Motor (50) automatisch so regeln, daß ein vorgegebener Laststrom durch die Impedanzmittel (35) aufrechterhalten wird.

2. Vorrichtung nach Anspruch 1, bei der die Kompressionsmittel eine sich durch die Impedanzmittel erstreckende drehbare Welle (40) sowie mit der Welle (40) in Gewindeeingriff stehende Mittel (43) aufweisen, die mit den Impedanzmitteln (35) in Eingriff bringbar sind, gekennzeichnet durch Mittel (55), die die Welle (40) mit dem elektrischen Motor (50) zwecks Drehung der Welle (40) kuppeln.

3. Vorrichtung nach Anspruch 1, dadurch gekennzeichnet, daß der elektrische Motor ein elektrischer Schrittmotor (50) ist, wobei die Antriebssteuermittel (60) Mittel (61) zur Abgabe eines binären Antriebssignals an den Schrittmotor (50) umfassen.

4. Vorrichtung nach Anspruch 1, dadurch gekennzeichnet, daß die Antriebssteuermittel (60) Mittel (58) zum manuellen Einstellen der Impedanzmittel (35) auf eine nominelle Null-Impedanz aufweisen.

5. Vorrichtung nach Anspruch 1, dadurch gekennzeichnet, daß die Rückkopplungsmittel (62) mit den Impedanzmitteln (35) in Reihe geschaltete Widerstandsmittel (63) sowie Mittel (70) zum Erfassen des Spannungsabfalls an den Widerstandsmitteln (63) aufweisen.

6. Vorrichtung nach Anspruch 5, gekennzeichnet durch Mittel (123) zum Anzeigen des Laststroms durch die Impedanzmittel (35).

7. Vorrichtung nach Anspruch 1, dadurch gekennzeichnet, daß die Antriebssteuermittel (60) Mittel (90) zum Vergleichen des Rückkopplungssignals mit einem Signal, das dem vorgegebenen Laststrom proportional ist, aufweisen.

8. Vorrichtung nach Anspruch 7, gekennzeichnet durch Mittel (124) zum Anzeigen des vorgegebenen Stroms.

9. Vorrichtung nach Anspruch 1, gekennzeichnet durch Zeitsteuermittel (110-121), die mit den Antriebssteuermitteln (60) gekoppelt sind, um die Zeitspanne zu steuern, während der der vorgegebene Laststrom aufrechterhalten wird.

10. Vorrichtung nach Anspruch 9, gekennzeichnet durch Mittel (117) zum Einstellen der Zeitspanne.

11. Vorrichtung nach Anspruch 1, dadurch gekennzeichnet, daß die Antriebssteuermittel aufweisen: Mittel (61,90,110) zum Verringern der Impedanz der Impedanzmittel (35), um den Laststrom von Null auf den vorgegebenen Laststrom zu erhöhen, wenn die Zeitspanne beginnt, und Mittel zum Vergrößern der Impedanz der Impedanzmittel (35), um den Laststrom von dem vorgegebenen Laststrom zurück auf Null zu verringern, wenn die vorgegebene Zeitspanne endet.

## Revendications

1. Dispositif (10) de charge automatique d'une batterie (B) pour tester cette dernière, comprenant : des moyens d'impédance à pile électrique au carbone (35) modifiables mécaniquement et aptes à être branchés en série avec la batterie (B) pour charger cette dernière, des moyens de compression (32-34, 38-45) couplés auxdits moyens d'impédance (35) pour modifier mécaniquement leur compression et produire de ce fait une modification de leur impédance, caractérisé par un moteur électrique (50) pour réaliser l'actionnement desdits moyens de compression (32-34; 38-45), des moyens de réaction (62) couplés auxdits moyens d'impédance (35) pour produire un signal de réaction proportionnel au courant de charge traversant lesdits moyens d'impédance (35) et des moyens de commande d'actionnement (60) couplés audit moteur (50) et auxdits moyens de réaction (62) répondant audit signal de réaction pour commander de façon automatique le fonctionnement dudit moteur (50) pour maintenir un courant de charge prédéterminé à travers lesdits moyens d'impédance (35).

2. Dispositif selon la revendication 1, dans lequel lesdits moyens de compression comprennent un arbre rotatif (40) qui traverse lesdits moyens d'impédance à pile au carbone, des moyens (43) coopérant par vissage avec ledit arbre (40) et adaptés pour venir en appui sur lesdits moyens d'impédance à pile au carbone (35), et caractérisé par des moyens (55) d'accouplement dudit arbre (40) audit moteur électrique (50) pour faire tourner ledit arbre (40).

3. Dispositif selon la revendication 1, caractérisé en ce que ledit moteur électrique est un moteur électrique pas-à-pas (50), lesdits moyens de commande d'activation (60) comprennent des moyens (61) pour appliquer un signal de commande binaire audit moteur pas-à-pas (50).

4. Dispositif selon la revendication 1, caractérisé en ce que lesdits moyens de commande d'actionnement (60) comprennent des moyens (58) pour ajuster manuellement lesdits moyens d'impédance à pile au carbone (35) dans un état d'impédance nominale nulle.

5. Dispositif selon la revendication 1, caractérisé en ce que lesdits moyens de réaction (62) comprennent des résistances (63) branchées en série avec lesdits moyens d'impédance à pile au carbone (35) et des moyens (70) pour détecter la chute de tension aux bornes desdites résistances (60).

6. Dispositif selon la revendication 5, caractérisé par des moyens (123) pour indiquer le courant de charge traversant lesdits moyens d'impédance à pile au carbone (35).

7. Dispositif selon la revendication 1, caractérisé en ce que lesdits moyens de commande d'actionnement (60) comprennent des moyens (90) pour comparer ledit signal de réaction à un signal proportionnel audit courant de charge prédéterminé.

8. Dispositif selon la revendication 7, caractérisé par des moyens (124) pour indiquer ledit courant prédéterminé.

9. Dispositif selon la revendication 1, caractérisé par des moyens de commande temporelle (110-121) couplés auxdits moyens de commande d'activation (60) pour commander l'intervalle de temps pendant lequel ledit courant de charge prédéterminé est maintenu.

10. Dispositif selon la revendication 9, caractérisé par des moyens (117) pour régler ledit intervalle de temps.

11. Dispositif selon la revendication 1, caractérisé en ce que lesdits moyens de commande d'actionnement (60) comprennent des moyens (61,90,110) de façon à réduire l'impédance desdits moyens d'impédance (35) de façon à accroître le courant de charge de zéro jusqu'audit courant de charge prédéterminé, lorsque ledit intervalle de temps commence, et des moyens pour augmenter l'impédance desdits moyens d'impédance (35) de façon à réduire le courant de charge depuis ledit courant de charge prédéterminé jusqu'à zéro, lorsque ledit intervalle de temps prédéterminé se termine.
